Europäisches Patentamt

European Patent Office

Office européen des brevets

(11) Publication number: **0 167 764**
**B1**

(12) **EUROPEAN PATENT SPECIFICATION**

(45) Date of publication of patent specification: **16.08.89**

(21) Application number: **85106321.4**

(22) Date of filing: **23.05.85**

(51) Int. Cl.⁴: **H 01 L 27/10, G 11 C 11/24**

(54) **Dynamic ram cell.**

(30) Priority: **14.06.84 US 620667**
**29.06.84 US 626512**

(43) Date of publication of application:
**15.01.86 Bulletin 86/03**

(45) Publication of the grant of the patent:
**16.08.89 Bulletin 89/33**

(84) Designated Contracting States:
**DE FR GB IT**

(56) References cited:
**EP-A-0 031 490**
**EP-A-0 108 390**
**EP-A-0 169 938**
**US-A-4 364 075**

**PATENTS ABSTRACTS OF JAPAN, vol. 8, no. 103 (E-244) 1540r, 15th May 1984 & JP - A - 59 19 366**

(73) Proprietor: **International Business Machines Corporation**
**Old Orchard Road**
**Armonk, N.Y. 10504 (US)**

(72) Inventor: **Lu, Nicky Chau-Chun**
**1424 Trout Brook Street**
**Yorktown Heights New York 10598 (US)**
Inventor: **Ning, Tak Hung**
**1720 Maxwell Drive**
**Yorktown Heights New York 10598 (US)**
Inventor: **Terman, Lewis Madison**
**Twin Lakes Road**
**South Salem New York 10590 (US)**

(74) Representative: **Appleton, John Edward**
**IBM United Kingdom Limited Intellectual Property Department Hursley Park**
**Winchester Hampshire SO21 2JN (GB)**

## Description

Technical field

This invention relates to a Dynamic Random Access Memory (DRAM) cell having a storage capacitor disposed in a semiconductor substrate.

Background of the invention

The recent literature has emphasized "one device" memory cell arrangements where higher and higher degrees of packing density and integration are being sought. This is achieved in most cases by juxtaposing access transistors and storage capacitors to achieve cell area reduction while at the same time increasing the storage capacitance, for example by decreasing oxide thickness, or increasing capacitor area.

An article entitled "Novel High Density, Stacked Capacitor MOS RAM" by M. Koyanagi et al, Proceedings of the 10th Conference on Solid State Devices, Tokyo, 1978; Japanese Journal of Applied Physics, Supplement 18-1, pp. 35-42 describes a Dynamic Random Access memory (DRAM) cell using a capacitor stacked on top of an associated access transistor. Because of the stacked configuration, the structure requires the use of three polysilicon layers which result in poor surface topology as well as increased processing difficulties. In addition, because the stacked capacitor is fabricated after the dopant profiles have been formed, it is difficult to fabricate shallow diffusion profiles. Apart from these factors, the structure is of interest because the capacitor structure is disposed over and in registry with the access transistor and the source of the latter is directly connected to one electrode of the capacitor.

An article entitled "A Corrugated Capacitor Cell (CCC) for Megabit Dynamic MOS Memories" by H. Sunami et al, IEEE Electron Device Letters, Vol. ED6-4, No. 4, April 1983, pp. 90—91, shows a one-device memory cell which is characterized by an etched-moat storage capacitor which extends into the substrate. The approach utilized results in an almost independent increase in storage capacitance without cell size enlargement. Structurally, the storage capacitor is disposed alongside an access transistor. The moat is insulated with a triple layer of $SiO_2/Si_3N_4/SiO_2$ and filled with polysilicon to form one plate of the capacitor. Because a depletion region is formed around the moat, when a positive potential is applied to the polysilicon capacitor electrode, a minimum spacing between moats is required to prevent punchthrough. This fact militates against denser packing of devices. In addition, from a structural point of view, there is no direct connection between a source/drain diffusion and the polycrystalline material disposed within the moat.

U.S.—A—4,397,075 filed July 3, 1980 shows a one-device memory cell where enhanced capacitance is obtained by extending the drain diffusion into a well etched in the semiconductor substrate. There is no separate capacitor element and the capacitance enhancement is a direct result of increasing the drain p-n junction area.

U.S.—A—4,327,476 filed November 28, 1980 shows a one-device memory cell which incorporates a capacitor electrode disposed in a groove or trench. The latter is formed alongside a source/drain diffusion and in insulated spaced relationship with the diffusion. There is no interconnection between the capacitor electrode in the trench and the source/drain diffusion

U.S.—A—4,225,945 filed June 6, 1977 shows a "V-groove" anisotropically etched storage capacitor for a one-device memory cell. In this arrangement, an inversion region created by applying a potential on an overlying capacitor plate acts as the other plate of the capacitor. The drain of the access transistor is the inversion region and enhanced capacitance is obtained by using a V-groove configuration to increase the capacitor area.

U.S.—A—4,116,720 filed December 27, 1977 shows one-device DRAM wherein capacitance is increased by increasing the junction capacitance of the device. In this reference, the source of the access transistor is disposed over the drain but there is no separate trench capacitor.

An article entitled "High-Density Single-Device Memory Cell" by F. Barson et al, in the IBM Technical Disclosure Bulletin, Vol. 16, No. 6, Nov. 1973, p. 1698 shows a memory cell wherein the storage capacitor is located over the access device. In the structure shown, one plate of the storage capacitor is connected to the source/drain of the access transistor. There is, however, no capacitor formed in a trench in the substrate.

A similar structure is shown in an article in the IBM Technical Disclosure Bulletin entitled "Vertical One-Device Memory Cell" by W. M. Smith, Jr., Vol. 15, No. 12, May 1973, p. 3585. The cell capacitor is formed from two polysilicon or metal layers which are stacked vertically over the access transistor. Also, the source/drain diffusion is directly connected to one of the capacitor plates. There is, however, no trench capacitor formed in the substrate.

Another article in the IBM Technical Disclosure Bulletin entitled "Memory Cell Structure" by S. A. Abbas et al, Vol. 18, No. 10, March 1976, p. 3288 shows a one-device memory cell wherein the capacitance of the cell is increased by increasing the junction capacitance, cj. by doping the substrate under the storage node diffusion. This arrangement shows no trench capacitor.

In still another article in the IBM Technical Disclosure Bulletin entitled "Very Dense One-Device Memory Cell' by C. G. Jambotkar, Vol. 25, No. 7, July 1982, p. 593, there is shown a one-device memory cell wherein the drain diffusion is formed around the periphery of a trench. The inside of the trench is covered with insulation and the remaining void may be filled with polyimide, polysilicon or $SiO_2$. While a trench is formed for the cell shown, no separate capacitor is formed therein. The structure shown does no more than lengthen the drain diffusion to thereby increase the junction capacitance.

An article entitled "A Submicron CMOS Megabit Level Dynamic RAM Technology Using Doped Face Trench Capacitor Cell" by K. Minegishi et al, IEDM 83, December 1983, pp. 319—322 discusses RAM cells in the CMOS environment and shows a trench the wall of which is heavily doped to form an extended source/drain region for an associated access transistor. A polycrystalline electrode is disposed in insulated space relationship with the substrate within the trench which acts as the counterelectrode of the capacitor. In this article, the substrate doesn't act as a counterelectrode inasmuch as a highly doped substrate would degrade the performance of associated transistors. In any event, there is no direct connection between the source of the access device and the electrode in the capacitor trench.

EP—A—108 390 (Hitachi, Ltd) describes a semiconductor memory comprising a capacitor with a data storage portion and an insulated-gate field effect transistor. The capacitor comprises as one main part a plate which consists of the side walls and base of a groove formed in the substrate, and as another part a capacitor electrode which is formed on the side walls and the base over an insulating film which is connected to the source of the transistor.

EP—A—169 938 (Toshiba) describes a semiconductor memory device having a trenched capacitor. The device comprises a memory having a p-type semiconductor substrate having a high impurity concentration in which a p-type semiconductor layer is formed on a surface thereof; a groove which is formed so as to extend from a surface of the semi-conductor layer to a position inside the semiconductor substrate; an impurity diffused region which is formed on portions of the semiconductor layer and the semiconductor substrate which define the groove; and an electrode which is formed from the groove to a level at least above an opening of the groove through a capacitor insulation film and electrode constituting a trenched capacitor in which the electrode serves as a first capacitor electrode and the impurity diffused region serves as a second capacitor electrode.

From all the foregoing, it should be clear that none of the above cited references provide a memory cell whereupon a capacitor is formed in a trench and the access device is vertically disposed over or laterally over and adjacent to the capacitor. In all the references where the capacitor and access transistor are vertically integrated, the capacitor is formed above the access transistor and, apart from processing difficulties, provides a structure having poor surface topology. Where trenches are used, they are disposed alongside and insulated from the source/drain diffusion, and density is limited by the fact that minimum distances must be maintained to prevent punchthrough. Finally, none of the references shows a highly doped substrrate which is capable of acting as a common capacitor electrode for a plurality of adjacent similar memory cells.

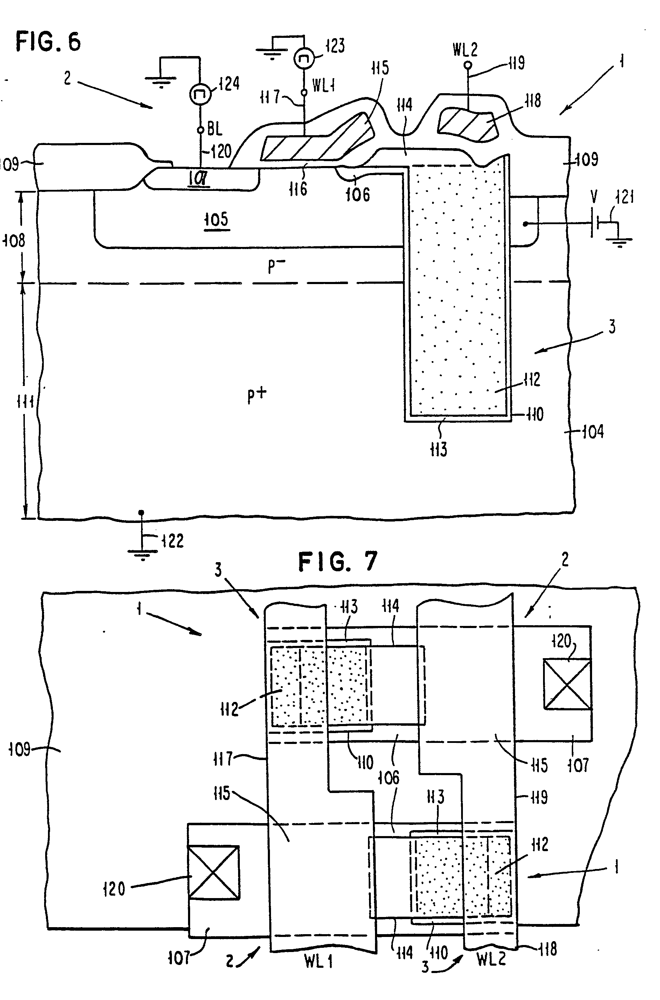

As regards the second embodiment herein (Figures 6—9), none of the cited references provide a memory cell wherein both the access transistor and its associated trench capacitor are formed in a well disposed in an opposite conductivity type substrate. As a result, prior art structures incorporating a well are limited as to the amount of capacitance which can be obtained because it was not perceived that the trench could penetrate through the well and achive most of the capacitive effect in the heavily doped counterelectrode portion of the substrate. Thus, none of the references cited show the combination of the access transistor and trench capacitor disposed in a well wherein the trench capacitor extends from the well or penetrates through the well to a highly doped substrate and wherein the source of the access transistor is directly connected to the electrode disposed inside the trench.

It is, therefore, one object of the present invention to provide a DRAM cell wherein the FET access transistor of the cell is disposed over and in registry with, or laterally over, the capacitor of the memory cell.

Another object is to provide a DRAM cell wherein one electrode of the cell capacitor is formed in a trench in an underlying semiconductor substrate in insulated spaced relationship with the substrate. The substrate itself forms the other electrode of the capacitor.

Another object is to provide a DRAM cell wherein the source of an associated FET access transistor is connected directly to the capacitor electrode disposed within the trench.

Still another object is to provide a DRAM cell wherein the area of the FET access transistor is approximately the same area as the area of the trench.

Yet another object is to provide a DRAM cell wherein the density of the cell is not limited by punchthrough considerations between adjacent cells. These objects are met by the invention as claimed in Claim 1.

Brief summary of the invention

The first embodiment of the present invention relates to a Dynamic Random Access Memory (DRAM) cell which utilizes an FET access transistor and a storage capacitor formed in a trench in a semiconductor substrate. The counterelectrode of the capacitor is provided by the substrate which is heavily doped to render it highly conductive. The electrode of the storage capacitor is formed from heavily doped polycrystalline silicon and is disposed in a trench formed in the substrate in insulated spaced relationship with the substrate. The FET access transistor is disposed over and in registry with the trench and, except for its source electrode, is electrically isolated from the substrate and the capacitor electrode. The source of the access transistor is directly connected to the capacitor electrode. In addition, the access transistor which is formed from recrystallized polycrystalline silicon is electrically isolated from every other access transistor. The access transistor has a polysilicon gate to which a word line of an array of such DRAM cells is connected. The drain of the FET access transistor is connected to a bit line which is similarly connected to the drain of other DRAM cells in an array. By applying appropriate word and bit line voltages to the access transistor, binary information may be written into and read from the storage capacitor.

A technique for fabricatng the first embodiment is also disclosed. The technique includes a recrystallization step which converts polycrystalline semiconductor to single crystal. It is this step which permits the total electrical isolation of the access transistor from other such devices. The resulting structure, in addition to having good surface topology, is capable of being formed into a high density array of such structures. Its density is neither impacted by the fact that the cell incorporates a trench capacitor nor is it subject to the minimum spacing requirements of prior art trench capacitors.

The second embodiment of the present invention relates to a Dynamic Random Access (DRAM) cell which utilizes an FET access transistor and a storage capacitor both of which are formed in a well in a semiconductor substrate. The well is of opposite conductivity type to that of the substrate and includes the source, drain and channel regions of the access transistor. Also included is a trench which extends through the well into a heavily doped substrate region which acts as the counter electrode of the storage capacitor. The electrode of the storage capacitor is disposed in insulated, spaced relationship with the substrate and may be made of heavily doped polycrystalline silicon. The electrode is connected by means of a bridge region to the source of the access transistor. A polysilicon gate disposed over the channel region completes the basic structure of the DRAM cell. The well formed in the substrate may be either p o n-conductivity type. Where the well is of one conductivity type, the substrate is of heavily doped opposite conductivity type and includes a more lightly doped region of like conductivity in which the well is disposed. The lightly doped region provides a transition from the heavily doped portion of the substrate of one conductivity type to the opposite conductivity type of the well to reduce the likelihood of breakdown at the junction between the regions. The heavily doped portion of the substrate, in addition to acting as the counterelectrode of the trench capacitor, makes the resulting memory cell less susceptible to soft errors due to alpha particle impingement.

In this cell, the well is biased to a fixed potential and the access transistor polysilicon gate forms part of a word line to which a plurality of DRAM cells of an array are connected. Similarly, the source/drain of the FET access transistor is connected to a bit line to which a plurality of drains of other DRAM cells in an array are connected. By applying appropriate word and bit line potentials to the access transistor, binary information may be written into and read from the storage capacitor.

A technique for fabricating the structure of this second embodiment is also disclosed. The process used does not depart greatly from processes used to fabricate Complementary Metal oxide Semiconductor (CMOS) devices. One significant deparature is that, after formation of a well in a lightly doped portion of the substrate, a trench is formed by reactive ion etching which extends from the surface of the well, through the well and into the heavily doped portion of the substrate. Thereafter, the trench is lined with insulating material and filled with polycrystalline silicon, a bridge region is formed which interconnects the electrode in the trench with the source region of the access transistor. A portion of the source region is formed when a portion of the bridge region out-diffuses dopant during a subsequent annealing step. The resulting structure has good surface topology and is not subject to minimum spacing requirements of prior art trench capacitors and is less subject to soft error occurrences found in prior art DRAM cells. The paired cell structure described affords good packing density.

The DRAM cell of the present invention may be implemented using both p-channel and n-channel access transistors. The conductivity type of the source and drain regions governs the conductivity type of the polycrystalline silicon used as the capacitor electrode.

These and other objects, features and advantages of the present application will be apparent from the following more particular description of a preferred embodiment.

Brief description of the drawings

Figure 1 is a cross-sectional view of a first embodiment of a DRAM cell according to the invention;

Figure 2 is a partial plan view of the DRAM celpf Figure 1,

Figures 3, 4, 5 are cross-sectional views of the structure of Figure 1 at different stages in its fabrication process;

Figure 6 is a partially schematic, cross-sectional view of a second embodiment of a DRAM cell according to the invention;

Figure 7 is a partial plan view of the DRAM cell of Figure 6 showing in addition, a paired second DRAM cell layout of an array;

Figures 8 and 9 are views of the structure of Figure 8 at different stages in its fabrication.

Description of the preferred embodiments

In what follows, the access transistor 2 will be characterized as having source and drain electrodes. For purposes of clarification, the drain electrode is that electrode which is connected to the bit line of a memory array.

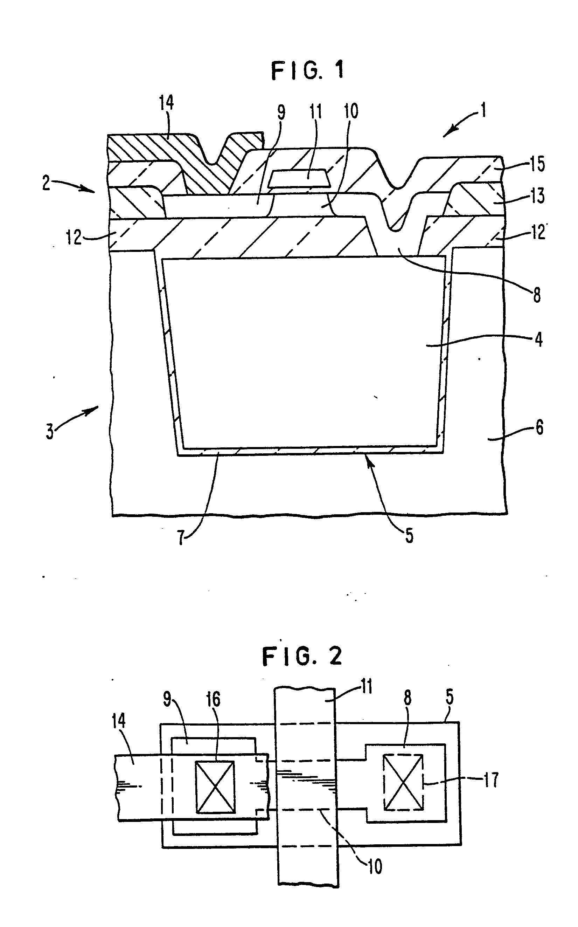

Referring now to Figure 1, there is shown a cross-sectional view of a three dimensional DRAM cell 1 wherein an access transistor 2 is stacked on top of a storage capacitor 3. The latter is formed from a conductive plug 4 of polycrystalline silicon or other suitable material disposed in a trench 5 which is etched in a heavily doped substrate 6 of $p^+$ silicon or other suitable semiconductor material. Substrate 6, for example, may be single crystal, polycrystalline or amorphous semiconductor materials which are heavily conductive. The sole criterion here is that the substrate be highly conductive. In Figure 1, polycrystalline plug 4 is spaced from substrate 6 by a layer 7 of high dielectric constant insulator. Layer 7 may be formed from a single high dielectric constant insulator such as silicon dioxide or may be formed from a composite of layers of silicon dioxide, silicon nitride and silicon dioxide.

Access transistor 2 consisting of a source 8, a drain 9, a channel region 10 and gate electrode 11 is shown in Figure 1 disposed over storage capacitor 3 and an intermediate layer 12 of insulation such as silicon dioxide. Elements 8, 9, 10 of access transistor 2 are formed in a layer of semiconductor material such as silicon or other suitable semiconductor material which is initially formed as a layer of polycrystalline silicon due to the presence of insulating layer 12 of silicon dioxide. The initially deposited polycrystalline layer is, however, subjected to a recrystallization step which converts the polycrystalline silicon into single crystal silicon.

In Figure 1, source 8 of access transistor 2 is connected directly to plug 4 which forms one electrode of storage capacitor 3. Substrate 6 forms the counterelectrode of storage capacitor 3 and, in an array of memory cells, like DRAM cell 1, substrate 6 forms a common counterelectrode for all such cells.

In Figure 1, the recrystallized region in which source 8, drain 9 and channel region 10 are formed is electrically isolated from other similar regions of other DRAM cells 1 by isolation regions 13 of an insulator like silicon dioxide. Finally, metallization 14 of aluminum or other suitable conductive material is connected to drain region 9 which acts as a bit line for DRAM cell 1 through layer 15 of insulation which also surrounds gate electrode 11. Layer 15 may be made of silicon dioxide or other suitable insulator material. In the structure of Figure 1, gate electrode 11 switches DRAM cell 1 and is connected to a word line which applies appropriate potentials to permit switching. DRAM cell 1 shown in Figure 1 is an n-channel device and source 8 and drain 9 are formed by introducing n-conductivity type dopants into the recrystallized layer in a concentration sufficient to render them highly conductive or $n^+$-conductivity type.

Gate electrode 11 and plug 4 are both polycrystalline in character and both are also $n^+$-conductivity type. Channel region 10 is of $p^-$-conductivity type by virtue of introducing a p-type dopant such as boron into the recrystallized region in a concentration sufficient to render it lightly doped or $p^-$-conductivity type. Substrate 6 is $p^+$-conductivity type a feature which permits substrate 6 to act as the counterelectrode of storage capacitor 3. At this point, it should be appreciated that all of the conductivity types mentioned above can be changed the conductivity type opposite to that indicated and an equally usable structure will result. The only change required would be to change the voltage which turns the device on from +5 volts to zero. This will become clear when the operation of DRAM cell 1 is discussed hereinbelow.

Figure 2 is a partial plan view of DRAM cell 1 of Figure 1 showing the layout of access transistor 2 and its relation to trench 5 in which plug 4 is formed. In Figure 2, metallization 14 is shown penetrating layer 15 by means of contact hole 16. Figure 2 also shows the outline of contact hole 17 by means of which source 8 penetrates insulator layer 12 and makes a connection with polycrystalline silicon plug 4. From Figure 2, it should be clear that the chip area available is fully used, and the capacitance obtained, due to its trench configuration, is much greater than that obtained from the usual planar capacitor structure.

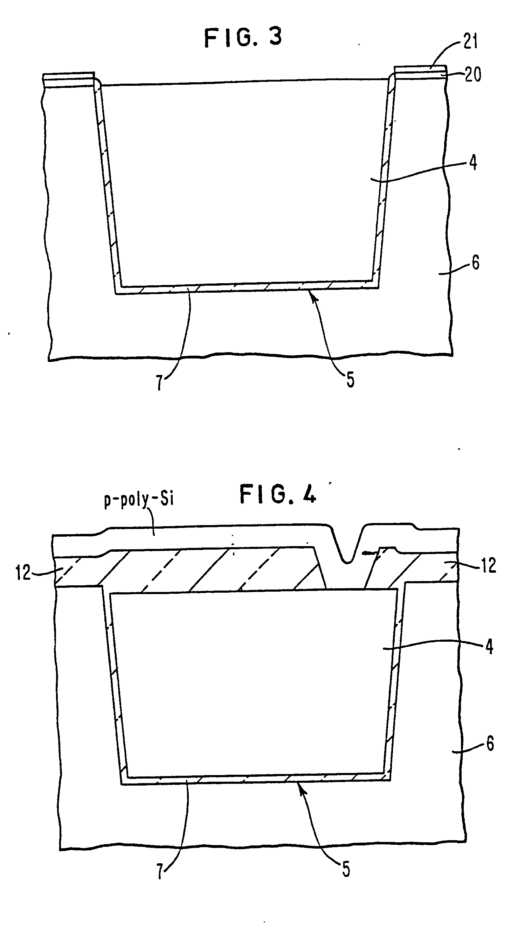

Referring now to Figure 3, there is shown a cross-sectional view of the device of Figure 1 at an intermediate stage in a process by which it is fabricated. Figure 3 shows polycrystalline plug 4 formed in trench 5 and disposed in insulated spaced relationship with trench 5 by means of high dielectric constant layer 7.

Trench 5 is formed in substrate 6 by first forming successive layers 20, 21 of silicon dioxide and silicon nitride, respectively, in any manner well-known to those in the semiconductor fabrication art on the surface of substrate 6 which has been heavily doped with a p-conductivity type dopant such as boron in a concentration of $1 \times 10^{19}$ atoms $cm^{-3}$. A photoresist layer is then formed over nitride layer 21, patterned and developed in a well-known way to provide a mask which will protect portions of layers 20, 21 and substrate 6 during a subsequent Reactive Ion Etching (RIE) step.

Using well-known RIE techniques which have high etching selectivity between the silicon of substrate 6 and nitride layer 21, unmasked portions of layers 21, 20 and substrate 6 are removed in that order until trench 5 is formed. Then, in a preferred approach, layer 7 is formed in trench 5 using alternating layers of oxide, nitride and oxide. The first oxide layer is a layer of thermally grown oxide which forms only on the surface of trench 5 since nitride layer 21 prevents growth elsewhere. Subsequently, a second layer of nitride is deposited by chemical vapor deposition on the surface of the thermally grown oxide. Then, the substrate is subjected to a thermal oxidation step which forms a thermally grown oxide in any pin-holes which might be present in the previously deposited nitride layer. The multilayer approach, in addition to eliminating pin-holes in the resulting layer, has the advantage that the nitride layer prevents out-diffusion of dopant from plug 4 which is to be formed from heavily doped polycrystalline silicon.

A layer of heavily doped polycrystalline silicon is then deposited using the chemical vapor deposition of silicon from silane doped with arsenic or phosphorus rendering the resulting layer $n^+$-conductivity type. Substrate 6 is then subjected to an RIE step producing polycrystalline plug 4 with a flat surface.

Because of growth requirements for laser recrystallized layers which will be discussed briefly in what follows, a region of substrate must remain unexposed during an oxidation step which is used to oxidize the remaining exposed surfaces of substrate 6 and the surface of polycrystalline plug 4. Thus, during the oxidation step to be described next, portions—not shown—of layers 20, 21 are retained and after the oxidation step is carried out, they are removed exposing portions of the surface of substrate 6 in which peripheral devices may typically be formed. These exposed substrate surface portions are now capable of supporting epitaxial silicon growth whereas polycrystalline silicon is formed over the oxide regions which are to be converted to epitaxial silicon in a subsequent recrystallization step.

Considering now Figure 4, there is shown the structure of Figure 1 at still another intermediate stage in its fabrication process. To arrive at this structure, nitride layer 21 is removed by wet etching in $H_3PO_4$ and oxide layer 20 is removed by wet etching in buffered HF. These steps expose the surface of substrate 6 everywhere except where it is desired to retain portions of these layers to mask the substrate against a following oxidation step. The surface of plug 4 is already exposed from the previously mentioned RIE step.

The exposed surfaces of substrate 6 and plug 4 are then subjected to an oxidation step which may be carried out by thermally growing or by CVD. The resulting oxide layer is insulator layer 12 shown in Figure 1. Layer 12 is then patterned and reactively etched to form a contact hole 17 as shown in Figure 2, by means of which a subsequently deposited layer of polycrystalline contacts the surface of plug 4. The layer of polycrystalline silicon is deposited over layer 12 and in contact hole 17 by CVD from silane.

Prior to deposition of the polycrystalline layer and after the formation of layer 12, portions—not shown—of substrate 6 which were masked by portions of layers 20, 21 are exposed by wet etching. When silicon is deposited from the vapor phase over layer 12, it has a polycrystalline character whereas silicon deposited on the newly exposed portions of substrate 6 is single crystal in character. The resulting layer is then ion implanted with boron in a manner well-known to those skilled in the semiconductor fabrication art to render it lightly doped or $p^-$-conductivity type. The concentration is $2 \times 10^{15}$ atoms $cm^{-3}$.

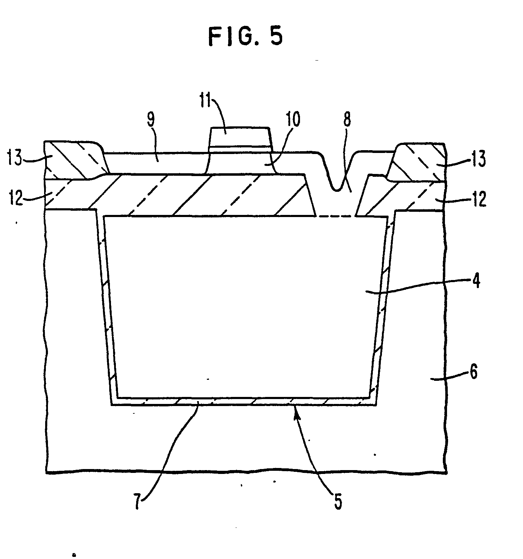

Considering now Figure 5, there is shown a cross-sectional view of the DRAM cell of Figure 1 at a still later stage in its fabrication process. After the ion implantation of the polycrystalline layer, the polycrystalline layer is covered with a layer 15 (Figure 1) of silicon oxide which acts as a stabilization layer during a following laser recrystallization step which converts the polycrystalline portions of polycrystalline silicon layer to single crystal material. The oxide stabilization layer is formed by a Low Pressure Chemical Vapor Deposition (LPCVD) in a well-known manner and is approximately 85 nm in thickness. With the stabilization layer in place, the underlying polycrystalline layer is then recrystallized using a cw argon laser or any other means such as strip heaters. One approach which may be utilized is described in an article entitled "CW Laser anneal of polycrystalline silicon: crystalline structure: electrical properties" by A. Gat et al, Applied Physics Letters, Vol. 33, pp 775—778, 15 Oct. 1978 which is hereby incorporated by reference. The epitaxial or single crystal portions—not shown—which were grown over exposed portions of substrate 6 are used as seed material to provide very large grain polysilicon. The laterally seeded polycrystalline portions, when recrystallized, optimize the characteristics of access transistor 2.

After the recrystallization step, the oxide stabilization layer is removed and a local oxidation step is carried out to oxidize those portions of the polycrystalline layer outside of the active device areas. To accomplish this, the active device areas are masked with a CVD nitride layer using well-known photolithographic masking and etching techniques. A thermal oxidation step is then performed producing isolation regions 13 surrounding access transistor 2 and any peripheral devices At this point, a deep boron ion implantation is carried out to prevent inversion of the n-channel polysilicon access transistors near the bottom of the recrystallized layer. The need for this implantation step arises from the fact that silicon dioxide layer 12 induces negative charge in what will be the channel region 10 of access transistor 2 forming a spurious n-channel in the lightly doped $p^-$-conductivity type region 10. By implanting positive charges in a concentration of about $10^{17}$ atoms $cm^{-3}$ near the bottom of region 10, the spurious n-channel is eliminated. Of course, if channel region 10 were of $n^-$-conductivity type, no implantation step would be required since the negative charges induced in region 10 would not form a spurious channel in such an n-type region. In a subsequent step, the layers of nitride and oxide used to mask regions during the formation of isolation regions 13 are removed. A thin gate oxide is thermally grown and a layer of $n^+$ polysilicon is deposited from n-doped silane. Polysilicon gate 11 is then formed using well-known photolithographic and etching techniques. Source 8 and drain 9 are then formed by the ion implantation of arsenic or phosphorous into the recrystallized polycrystalline silicon layer using gate electrode 11 as a mask. Gate electrode 11 is rendered highly conductive or $n^+$-conductivity type during the same implantation step. In this manner, source 8 is now conductively connected to plug 4 which forms the electrode of storage capacitor 3. Figure 5 shows the structure of DRAM cell 1 after the ion implantation of source 8, drain 9 and gate electrode 11. These elements are doped to a level of $1 \times 10^{20}$ atoms $cm^{-3}$.

In subsequent steps, insulation layer 15 (Figure 1) is formed; contact hole 16 is formed by masking and etching and metallization 14 is deposited and patterned in the usual way. Metallization 14 may be made of aluminum or any other suitable conductive material. These final steps result in the structure shown in Figure 1. The fabrication process described requires only six masks (not including the passivation mask) and results in a DRAM cell wherein the substrate is heavily doped to form one electrode of a trench capacitor while a heavily doped polycrystalline plug disposed in insulated spaced relationship from the substrate forms the other electrode of the trench capacitor. That electrode and the source of an associated access transistor are connected together. The resulting one-device DRAM cell 1 consisting of access transistor 2 and storage capacitor 3 requires no more area than the area of trench 5 and, as a result, very high device density is obtained as well as a large increase in storage capacitance. In addition, bit line capacitance is decreased, susceptibility to soft error is reduced and good surface topography is obtained. DRAM cell 1 may typically be laid out in an area which is approximately the area of the top of trench 5. The second embodiment of the invention described hereinafter differs in this respect.

In operation, DRAM cell 1 has potentials of either 0 or 5 volts applied via metallization 14 to drain 9 which is effectively the bit line for cell 1. At the same time, the substrate 6 is grounded, and 5 volts is applied to gate 11 rendering access transistor conductive. Thus, with substrate 6 grounded, a binary "1" may be written into storage capacitor 3 by applying 5 volts to both drain 9 and gate electrode 11 charging electrode 4 to a potential of 5 volts minus the threshold voltage of access transistor 2. A binary "0" may be written into storage capacitor 3 by applying 5 volts to gate electrode 11 and zero volts to drain 9 charging electrode 4 to approximately zero volts. Both binary states may be read by applying 5 volts to gate electrode 11.

As previously indicated, the conductivity types shown in DRAM cell 11 may be changed to the opposite conductivity type without departing from the spirit of the present invention. Thus, with substrate 6 grounded, a binary "0" may be written into storage capacitor 3 by applying zero volts to both drain 9 and gate electrode 11 charging electrode 4 to a potential of the absolute value of the threshold voltage of access transistor 2.

A binary "1" may be written into storage capacitor 3 by applying zero volts to gate electrode 11 and (minus) five volts to drain 9 charging electrode 4 to (minus) five volts. Both binary states may be read by applying zero volts to gate electrode 11.

Referring to Figure 6, there is shown a partially schematic, cross-sectional view of a Dynamic Random Access Memory (DRAM) cell 1 which includes a field effect Access transistor 2 and a trench capacitor 3 both of which are formed in a semiconductor substrate 104 preferably of silicon. Access transistor 2 is formed in an n-well 105 and includes source region 106 and drain region 107 of heavily doped $p^+$-conductivity type. N-well 105 is disposed in a lightly doped $p^-$-conductivity type portion 108 of substrate 104. Recessed oxide (ROX) regions 109 isolate memory cell 1 from other similar memory cells formed on substrate 104. In Figure 6, trench capacitor 3 is formed from a trench 110 which extends from the surface of substrate 104 through n-well 105 and lightly doped substrate portion 108 into a heavily doped $p^+$-conductivity type portion 111 of substrate 104. A plug 112 of heavily doped $p^+$-conductivity type polycrystalline silicon is disposed in trench 110 and insulated from substrate 104 by means of a layer 113 of insulation. Layer 113 may be a single layer of silicon dioxide or preferably may be a composite triple layer made up of layers of silicon dioxide, silicon nitride and silicon dioxide. Source region 106 and plug 112 are electrically and physically interconnected (directly within the cell structure) by means of a bridge region 114 of heavily doped p-conductivity type polycrystalline silicon. Region 114 may be made of any conductive material provided it is compatible with the process being utilized. A gate electrode 115 of heavily doped $n^+$-conductivity polycrystalline silicon is shown disposed over and insulated from the channel region between source region and drain region by a thin gate oxide 116. Gate electrode 115 is connected via interconnection 117 (WL1) to other gate electrodes of an array of DRAM cells 1.

In Figure 6, a heavily doped $n^+$-conductivity polycrystalline silicon element 118 is shown disposed over plug 112 and insulated from it by oxide. Element 118 forms a connection to the gate electrodes of adjacent DRAM cells 1 and results in a considerable saving in memory cell area because the area over trench capacitor 3 can be utilized without any degradation in device characteristics. Element 118 is connected via interconnection 119 (WL2) to other gate electrodes of the array of DRAM cells 1.

Drain region 107 acts as the bit line for a plurality of DRAM cells 1 which are all connected to one of the bit lines of an array of DRAM cells 1. Drain region 107 is connected to other device drains via interconnection 120 otherwise identified in Figure 6 as BL. While not specifically shown in Figure 6 interconnection 120 is normally formed from metallization such as aluminum.

Figure 6 shows a voltage source 121, otherwise identified therein as V, connected to n-well 105 to provide a bias to it. Substrate 104 is shown connected to ground via interconnection 122. Also, pulsed voltage sources 123, 124 are shown in Figure 6 connected to interconnections 117, 120, respectively These sources, when activated, write binary information into trench capacitor 3. The activation of source 123 reads binary information from trench capacitor 3. Specific voltages will be discussed below when the operation of DRM cell 1 is discussed in some detail.

At this point, it should be noted that trench capacitor 3 penetrates through the p-n junction between n-well 105 and the lightly doped, $p^-$-conductivity type portion 108, and, as a result, the capacitance obtainable is not limited like it is in prior art arrangements where the capacitance obtainable is limited by the thickness of the epitaxial layer.

Referring now to Figure 7, there is shown a plan view of DRAM cell 1 shown in Figure 6. In the layout drawing of Figure 7 both the relationship of trench capacitor 3 to access transistor 2 and the relationship of DRAM cell 1 to an adjacent similar DRAM cell 1 are shown. To achieve area conservation, trench capacitor 3 is first disposed adjacent the right-hand side of lower DRAM cell 1 in Figure 7. For the uppermost of the two DRAM cells 1 shown in Figure 7, trench capacitor 3 is diposed adjacent the left-hand side of cell 1 and in line with the interconnection 117. The area over this trench capacitor 3 is covered with oxide. In this way, WL1 or interconnection 117 is connected to gate electrode 115 of the lowermost DRAM cell 1 and extends over trench capacitor 3 of the uppermost DRAM cell 1 in Figure 7. In a similar way, WL2 is connected to gate electrode 115 of the uppermost DRAM cell 1 and extends over trench capacitor 3 of the lowermost DRAM cell 1. By repeating the pattern for pairs of DRAM cells 1 as shown in Figure 7, considerable savings in area can be obtained.

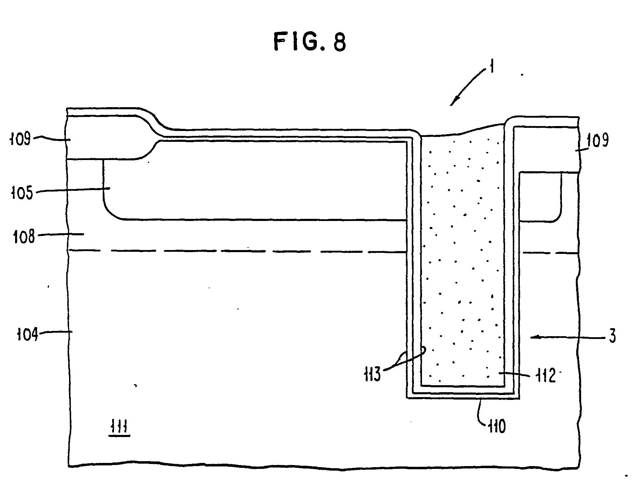

Referring now to Figure 8, there is shown a cross-sectional view of the structure of Figure 6 at an intermediate stage in its fabrication process after n-well 105 ROX regions 109 and trench capacitor 3 have been created. The fabrication of DRAM cell 1 is begun by depositing an epitaxial layer of $p^-$-conductivity type silicon from silane doped with boron on $p^+$-conductivity type portion 111 to form portion 108 of silicon substrate 104 in which access transistor 2 and trench capacitor 3 are to be formed. The doping level in portion 108 is $2 \times 10^{15}$ atoms $cm^{-3}$ while that in portion 111 is $1 \times 10^{19}$ atoms $cm^{-3}$.

After depositing substrate portion 108, a layer of oxide is thermally grown on its surface. A layer of photoresist is deposited on the oxide layer and is patterned using well-known techniques to form an opening through which ions will be implanted to form n-well 105. In order to obtain a retrograde doping profile in n-well 105, a deep ion implantation step followed by a shallow ion implantation are carried out. The deep ion implantation step provides a high conductivity region near the bottom of n-well 105 which eliminates noise problems which might arise if n-well 105 remained highly resistive. Either arsenic or phosphorus is ion implanted in a well-known way to a depth which does not penetrate through portion 108 of substrate 104. The latter is then annealed to activate the implanted species. The implanted dopant has a concentration of $10^{17}$ atoms $cm^{-3}$ near the bottom of the implant while it is $2 \times 10^{16}$

atoms $cm^{-3}$ near the surface of n-well 105. After the surface is thermally oxidized, a nitride layer is deposited everywhere. A layer of photoresist is then deposited and patterned in a well-known way to permit the etching of openings in the nitride and oxide layers to expose portions of the surface of substrate 104 where ROX regions 109 are to be formed. Etchants such as $H_3PO_4$ and buffered HF are used to etch the nitride and oxide, respectively. Using a thermal oxidation step, after stripping the photoresist, ROX regions 109 are formed which isolate DRAM cell 1 electrically from other similar cells formed on substrate 104.

As a prelude to the formation of trench 110 in substrate 104, a photoresist layer is deposited and patterned over the nitride layer. Substrate 104 is then subjected to a Reactive Ion Etching (RIE) step whereby the unmasked portion of substrate 104 is removed down to a desired depth. In the process, unmasked portions of nitride, oxide and substrate portions 108, 111 are removed in that order until trench 110 is formed. Then, in a preferred approach, layer 113 is formed on the surface of trench 110 using alternating layers of oxide, nitride and oxide. The first oxide layer is a layer of thermally grown oxide which forms only on the surface of trench 110 since a nitride layer still masks the surface of substrate 104. Subsequently, a layer of nitride is deposited everywhere by chemical vapor deposition on the surface of the thermally grown oxide, on the nitride layer between ROX regions 109 and on ROX regions 109. Then, substrate 104 is subjected to a thermal oxidation step which forms a thermally grown oxide in any pinholes which might be present in the previously deposited nitride layer. The multilayer approach, in addition to eliminating pinholes in the resulting layer, prevents out-diffusion of dopant from plug 112 which is to be formed from heavily doped $p^+$-polycrystalline silicon because the nitride layer is an effective diffusion barrier.

A layer of heavily doped polycrystalline silicon is then deposited using the chemical vapor deposition of silicon from silane doped with boron to render the resulting layer $p^+$-conductivity type. The layer is deposited in a thickness sufficient to fill trench 110. Substrate 104 is then subjected to an RIE planarization step to remove the polycrystalline layer everywhere down to the top of trench 110. The nitride layer deposited during the formation of trench insulation layer 113 and the nitride layer between the ROX regions 109 act as the etch stops during the RIE planarization step using a well-known optical endpoint detect technique. At this point, DRAM cell 1 has the structure shown in cross section in Figure 8.

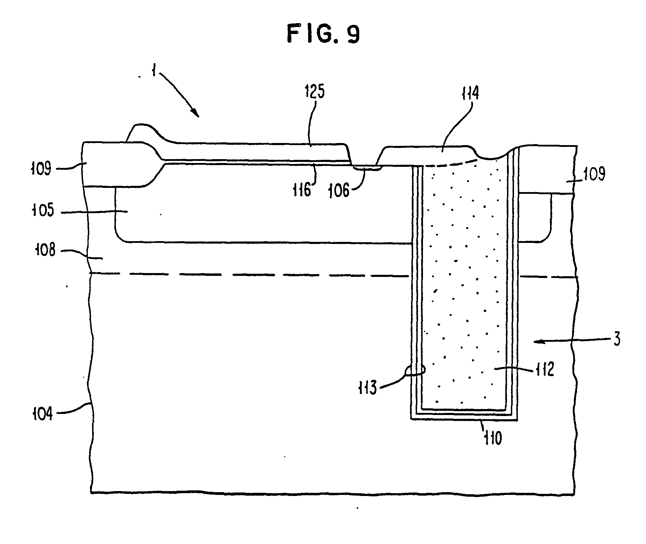

Figure 9 shows a cross-sectional view of the device of Figure 6 at another intermediate stage in its fabrication after a thin, heavily doped $p^+$-conductivity type layer has been deposited and patterned to form bridge region 114 over insulation layer 113 between source region 106 of access transistor 2 and plug 112.

The structure of Figure 9 is obtained by first adding a nitride layer 125 on top of the oxide and nitride layers which were formed during the formation of layer 113 on the inside of trench 110. Layers 116, 125 are then covered with a layer of photoresist. The latter is patterned and developed in a well-known manner exposing a portion of nitride layer 125. Then, using RIE, portions of nitride layer 125 and oxide layer 116 are removed exposing a portion of substrate 104 in which a portion of source region 106 is to be formed, the top of plug 112 and ROX regions 109. A thin layer of heavily doped $p^+$-conductivity type polycrystalline silicon is deposited from boron doped silane and patterned using well-known photolithographic and etching techniques to form bridge region 114 which interconnects source region 106 and the top of plug 112 which are spaced from each other by a portion of insulation layer 113. The patterning of the polycrystalline layer leaves a surface portion of substrate 104 exposed. Using well-known ion implantation techniques, a very shallow boron implant is made in the exposed portion of substrate 104 forming a portion of source region. The remaining portion of source region 106 is formed by out-diffusion of dopant from bridge region 114 during an annealing step which activates the shallow boron implant. It should be noted that the out-diffused portion of source region 106 is butted against insulator layer 113 resulting in cell area reduction.

At this point, using nitride layer 125 as a mask, an oxide layer is thermally grown and forms insulation over the exposed portion of substrate 104, bridge region 114 and any remaining exposed surface of plug 112. At the same time, ROX region 109 undergoes further growth thereby increasing its thickness from that provided in the initial ROX growth step. Because it was recognized that a step would be taken later on in the process which was tantamount to another ROX growth step, the initial ROX growth step was limited to produce a rather thin ROX region. As a result, RIE etching of trench 110 through ROX region 109 was simplified and ROX bird's beak formation was reduced.

After the growth of the last mentioned oxide layer, nitride layer 125 is removed by wet etching. A layer of heavily doped $n^+$-conductivity type polycrystalline silicon is deposited and patterned using conventional photolithographic and etching techniques to form gate electrode 115 and element 118, 119 which connects to the gate electrodes of adjacent cells as shown in Figure 7. At this point, substrate 104 is subjected to a boron ion implantation step which forms self-aligned drain region 107 in substrate 104 using a ROX region 109 and gate electrode 115 as an implantation mask. The dopant concentrations in both drain region 107 and source region 106 are $1 \times 10^{20}$ atoms $cm^{-3}$ and $1 \times 10^{19}$ atoms $cm^{-3}$, respectively. After implanting drain region 107, substrate 104 is subjected to a thermal oxide growth step to insulate gate electrode 115, element 118 and the surface of substrate 104 in which drain region 107 was implanted. Metallization is then applied after a deposited photoresist layer is exposed, patterned and developed.

At this point, it should be appreciated that, while only a single DRAM cell 1 has been shown in Figure 6 a plurality of DRAM cells 1 are normally formed in n-well 105 and fabricated simultaneously therein in the same manner as described hereinabove. It should also be appreciated that, while an n-well 105 has been shown in Figure 6 a p-well may just as easily be used. Then, of course, the conductivity types of source and drain regions 106, 107, respectively, and substrate portions 108, 111 should be changed to n-conductivity type.

The DRAM cell described above is compatible with epitaxial CMOS technology. As previously indicated, higher packing density is achievable because of the elimination of punch-through current between trenches and low soft error rates are obtained. Also, stored charge is disturbed much less in the present cell. Finally, the resulting structure has a relatively flat surface topology.

In operation, DRAM cell 1 has potentials of either zero or five volts applied to drain 107 of access transistor 2 from pulsed source 124. At the same time either zero or five volts is being applied to drain 107, zero volts is applied to gate electrode 115 rendering access transistor 2 conductive. Thus, with substrate 104 grounded, a binary "1" may be written into storage capacitor 3 by applying five volts to drain 107 and zero volts to gate electrode 115 charging electrode or plug 112 to a potential of five volts. A binary "0" may be written into storage capacitor 3 by applying zero volts to both drain 107 and gate electrode 115 charging electrode 112 to a potential equal to the absolute value of the transistor threshold. Both binary states may be read by applying zero volts to gate electrode 115.

As previously indicated, the conductivity types shown in DRAM cell 1 may be changed to opposite conductivity type without departing from the spirit of the present invention. Thus, with substrate grounded, a binary "1" may be written into storage capacitor 3 by applying (minus) five volts to both drain 107 and gate electrode 115 charging electrode 112 to a potential of (minus) five volts minus the threshold voltage of access transistor 2. A binary "0" may be written into storage capacitor 3 by applying zero volts to drain 107 and (minus) five volts to gate electrode 115 charging electrode 112 to approximately zero volts. Both binary states may be read by applying (minus) five volts to gate electrode 115.

**Claims**

1. A dynamic random access memory cell comprising:
   a semiconductor substrate (6) at least a portion of which is highly conductive,
   a trench (5) in said substrate,
   a conductive element (4) disposed in said trench in insulated spaced relationship with said substrate, said conductive element and said highly conductive portion of the substrate being storage capacitor electrodes for the cell,

and a field effect transistor (2) disposed over said trench and lying within the periphery of said trench on the surface of the substrate and having source (8), drain (9) and gate (11) electrodes disposed adjacent to said conductive element, said source electrode being connected to said conductive element, characterised in that said field effect transistor comprises;

a layer of semiconductor material having drain, source and channel regions therein disposed on an insulation layer (12), said source region having a portion which extends through a via hole in said insulation layer (12) and contacting the surface of said conductive element, and a gate electrode disposed in insulated spaced relationship over said channel region, and being arranged horizontally over the capacitor.

2. A dynamic random access memory cell according to Claim 1 wherein said conductive element is heavily doped polycrystalline silicon.

3. A dynamic random access memory cell according to Claim 1 or Claim 2 wherein said layer of semiconductor material is a layer of recrystallized polycrystalline silicon.

4. A dynamic random access memory cell according to Claim 1 wherein a layer comprised of silicon dioxide and silicon nitride provides said insulated spaced relationship between said conductive element and said substrate.

5. A dynamic random access memory cell as claimed in Claim 1 in which said substrate (104) includes a well region (105) of opposite conductivity type,

said field effect transistor being formed in said well region and said conductive element (112) extending from the surface of said well through the well and further into said substrate, and wherein said substrate includes a heavily doped portion (111) and a lightly doped portion (108) disposed over said heavily doped portion, said well region being in said lightly doped portion.

6. A dynamic random access memory cell according to Claim 5 including a region (114) of polycrystalline semiconductor material interconnecting the source electrode (106) of the field effect transistor and said conductive element.

7. A dynamic random access memory cell according to Claim 5 in combination with a second cell oppositely arranged in the substrate having regard to its associated field effect transistor and conductive element, the gate electrode (115) of the first cells field effect transistor being part of a first conductive line (WL1) which includes a portion of reduced width extending over the conductive element (112) of the second cell, and the gate electrode of the second cell's field effect transistor being part of a second conductive line (WL2) which includes a portion of reduced width extending over the conductive element of the first cell.

## Patentansprüche

1. Dynamische RAM-Zelle bestehend aus:

einem Halbleitersubstrat (6), von dem mindestens in Teil gut leitend ist,

einem Graben (5) in diesem Substrat,

einem leitenden Element (4) das in diesen Graben eingebettet ist und zu dem Substrat in isolierendem Abstand. gelegen ist, wobei dieses leitende Elemente und der gut leitende Teil des Substrats die Elektroden des Speicherkondensators der Zelle sind,

und einem Feldeffekttransistor (2), der über diesem Graben angeordnet ist und innerhalb der Berandung des Grabens auf der Oberfläche des Substrates liegt, und dessen Source (8), Drain (9) und Gateelektroden (11) angrenzend an das leitende Elemente gelegen sind, wobei die Sourceelektrode an das leitende Element angeschlossen ist, durch gekennzeichnet, daß dieser Feldeffekttransistor folgendes enthält:

eine Schicht aus halbleitendem Material, welche Drain-, Source- und Kanalbereiche aufweist, die auf einer isolierenden Schicht (12) angeordnet sind, wobei der Sourcebereich einen Abschnitt aufweist, der sich über ein Kontaktloch in die Isolationsschicht (12) erstreckt und die Oberfläche des leitenden Elements kontaktiert, und eine Gateelektrode, welche in isolierendem Abstand über dem Kanalbereich angeordnet ist und welche waagrecht über dem Kondensator liegt.

2. Dynamische RAM-Zelle nach Anspruch 1, bei welcher das leitende Element hochdotiertes polykristallines Silizium ist.

3. Dynamische RAM-Zelle nach Anspruch 1 oder Anspruch 2, bei welcher die Schicht aus halbleitendem Material eine Schicht aus umkristallisiertem polykristallinem Silizium ist.

4. Dynamische RAM-Zelle nach Anspruch 1, bei welcher eine Schicht aus Siliziumdioxid und Siliziumnitrid den isolierenden Abstand zwischen dem leitenden Element und dem Substrat herstellt.

5. Dyanmische RAM-Zelle nach Anspruch 1, bei welcher das Substrat (104) einen Vertiefungsbereich (105) von entgegengesetztem Leitungstyp aufweist,

wobei der Feldeffekttransistor in diesem Vertiefungsbereich gebildet ist und das leitende Element (112) sich von der Oberfläche der Vertiefung aus über die Vertiefung hindurch und weiter in das Substrat erstreckt, und wobei dieses Substrat einen hochdotierten Teil (111) und einen schwachdotierten Teil (108), der über dem hochdotierten Teil liegt, aufweist und der Vertiefungsbereich in diesem schwach dotierten Teil angeordnet ist.

6. Dynamische RAM-Zelle nach Anspruch 5, welche einen Bereich (114) aus polykristallinem halbleitendem Material aufweist, welcher die Sourcelektrode (106) des Feldeffekttransistors mit dem leitenden Elemente verbindet.

7. Dynamische RAM-Zelle nach Anspruch 5 in Kombination mit einer zweiten Zelle, die hinsichtlich ihres zugehörigen Feldeffekttransistors und leitenden Elementes gegenüberliegend auf dem Substrat angeordnet ist, wobei die Gateelektrode (115) das Feldeffekttransistors der ersten Zelle Teil eines ersten Leiters (WL1) ist, welcher einen Abschnitt von verjüngter Breitge aufweist, der sich über dem leitenden Element (112) der zweiten Zelle erstreckt, und wobei die Gateelektrode des Feldeffekttransistors der zweiten Zelle Teil eines zweiten Leiters (WL2) ist, welcher einen Abschnitt von verjüngter Breite aufweist, der sich über dem leitenden Element der ersten Zelle erstreckt.

## Revendications

1. Cellule de mémoire vive dynamique, comprenant:

un substrat semi-conducteur (6) dont au moins une partie est très conductrice,

une tranchée (5) formée dans ledit substrat,

un élément conducteur (4) disposé dans ladite tranchée en relation espacée et isolée avec ledit substrat, ledit élément conducteur et ladite partie très conductrice du substrat constituant les électrodes de condensateur de stockage pour la cellule,

et un transistor à effet de champ (2) disposé au-dessus de ladite tranchée et situé à l'intérieur de la périphérie de ladite tranchée sur la surface du substrat et comportant des électrodes de source (8), de drain (9) et de grille (11) adjacentes audit élément conducteur, ladite électrode de source étant connectée audit élément conducteur, caractérisée en ce que ledit transistor à effet de champ comprend:

une couche de matière semi-conductrice comportant des régions de drain, de source et de canal disposées sur une couche d'isolation (12), ladite région de source comportant une partie qui s'étend à travers un trou de traversée ménagé dans ladite couche d'isolation (12) et qui vient en contact avec la surface dudit élément conducteur, et une électrode de grille disposée en relation espacée isolée au-dessus de ladite région de canal, et agencée horizontalement au-dessus du condensateur.

2. Cellule de mémoire vive dynamique suivant la revendication 1, dans laquelle ledit élément conduteur est du silicium polycrystallin fortement dopé.

3. Cellule de mémoire vive dynamique suivant la revendication 1 ou la revendication 2, dans laquelle ladite couche de matière semi-conductrice est une couche de silicium polycristallin recristallisé.

4. Cellule de mémoire vive dynamique suivant la revendication 1, dans lequelle une couche composé de dioxyde de silicium et de nitrure de silicium procure ladite relation espacée et isolée entre ledit élément conducteur et ledit substrat.

5. Cellule de mémoire vive dynamique suivant la revendication 1, dans laquelle ledit substrat (104) comprend une région de puits (105) de type de conductivité opposé,

ledit transistor à effet de champ étant formé dans ladite région de puits et ledit élément conducteur (112) s'étendant à partir de la surface dudit puits, à travers le puits et pénétrant dans ledit substrat, et dans laquelle ledit substrat comprend une partie fortement dopée (111) et une partie légèrement dopée (108), disposée au-dessus de ladite partie fortement dopée, la dite région de puits étant dans la dite partie légèrement dopée.

6. Cellule de mémoire vive dynamique suivant la revendication 5, comprenant une région (114) de matière semi-conductrice polycrystalline interconnectant l'électrode de source (106) du transistor à effet de champ et ledit élément conducteur.

7. Cellule de mémoire vive dynamique suivant la revendication 5, en combaison avec une deuxième cellule disposée de façon opposée dans le substrat en ce qui concerne son transistor à effet de champ associé et son élément conducteur, l'électrode de grille (115) du transistor à effet de champ de la première cellule faisant partie d'une première ligne conductrice (WL1) qui comprend une partie de largeur réduite s'étendant au-dessus de l'élément conducteur (112) de la deuxième cellule, et l'électrode de grille du transistor à effet de champ de la deuxième cellule faisant partie d'une deuxième ligne conductrice (WL2) qui comprend une partie de largeur réduite s'étendant au-dessus de l'élément conducteur de la première cellule.

FIG. 1

FIG. 2

FIG. 3

p-poly-Si

FIG. 4

# FIG. 5

**FIG. 6**

**FIG. 7**

4

# FIG. 8

# FIG. 9